(19) **Europäisches Patentamt / European Patent Office / Office européen des brevets**

(11) **EP 2 727 107 B1**

(12) **FASCICULE DE BREVET EUROPEEN**

(45) Date de publication et mention
de la délivrance du brevet:
**15.05.2019 Bulletin 2019/20**

(21) Numéro de dépôt: **12734996.7**

(22) Date de dépôt: **26.06.2012**

(51) Int Cl.:
***G10L 19/022*** *(2013.01)*

(86) Numéro de dépôt international:
**PCT/FR2012/051463**

(87) Numéro de publication internationale:
**WO 2013/001226 (03.01.2013 Gazette 2013/01)**

(54) **FENÊTRES DE PONDÉRATION EN CODAGE/DÉCODAGE PAR TRANSFORMÉE AVEC RECOUVREMENT, OPTIMISÉES EN RETARD**

VERZÖGERUNGSOPTIMIERTE KODIERUNGS-/DEKODIERUNGS-GEWICHTUNGSFENSTER DURCH ÜBERLAPPUNGSTRANSFORMATION

DELAY-OPTIMIZED OVERLAP TRANSFORM, CODING/DECODING WEIGHTING WINDOWS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **28.06.2011 FR 1155769**

(43) Date de publication de la demande:
**07.05.2014 Bulletin 2014/19**

(73) Titulaire: **Orange**
**75015 Paris (FR)**

(72) Inventeurs:
• **FAURE, Julien**
**F-22300 Ploubezre (FR)**
• **PHILIPPE, Pierrick**
**F-35520 Melesse (FR)**

(74) Mandataire: **Cabinet Plasseraud**
**66, rue de la Chaussée d'Antin**
**75440 Paris Cedex 09 (FR)**

(56) Documents cités:
**WO-A1-2009/081003**

**Description**

L'invention se situe dans le domaine du codage/décodage de signaux audionumériques, plus spécifiquement dans le domaine dit du « codage/décodage audio par transformée avec recouvrement ».

Le « codage par transformée » consiste à coder des signaux temporels dans le domaine transformé (fréquentiel). Cette transformation permet notamment d'utiliser les caractéristiques fréquentielles des signaux audio (musicaux, de parole, ou autres) afin d'optimiser et améliorer les performances de codage. On utilise par exemple le fait qu'un son harmonique est représenté dans le domaine fréquentiel par un nombre fini et réduit de raies spectrales qui peuvent ainsi être codées de manière concise. On utilise aussi par exemple avantageusement des effets de masquage fréquentiels pour mettre en forme le bruit de codage de manière à ce qu'il soit le moins audible possible.

Une technique habituelle de codage par transformée peut être résumée comme suit.

Le flux audionumérique (échantillonné à une fréquence d'échantillonnage Fs donnée), à coder, est sectionné en trames (ou « blocs », plus généralement) de nombre d'échantillons 2M finis. Chaque trame se recouvre classiquement à 50 % avec la trame précédente. Une fenêtre de pondération $h_a$ (appelée « fenêtre d'analyse ») est appliquée à chaque trame.

Une transformation est ensuite appliquée au signal. Dans le cas d'une transformation dite « MDCT » (pour « Modified Discrète Cosine Transform »), et dans une réalisation particulière, la trame pondérée est « repliée » suivant une transformation 2M échantillons vers M échantillons. Une transformée DCT de type IV est ensuite appliquée à la trame repliée afin d'obtenir une trame de taille M dans le domaine transformé.

La trame dans le domaine transformé est alors quantifiée en utilisant un quantificateur adapté. La quantification permet de réduire la taille des données, mais introduit un bruit (audible ou non) dans la trame originale. Plus le débit du codeur est élevé, plus ce bruit est réduit et plus la trame quantifiée est proche de la trame originale.

Au décodage, une transformation MDCT inverse est alors appliquée à la trame quantifiée. La trame quantifiée de taille M est convertie en trame de taille M dans le domaine temporel en utilisant une DCT de type IV inverse. Une deuxième transformation de « dépliage » de M vers 2M est alors appliquée à la trame temporelle de taille M.

Des fenêtres de pondération $h_s$ dites de « synthèse » sont appliquées ensuite aux trames de tailles 2M.

Le flux audio décodé est alors synthétisé en sommant les parties en recouvrement.

Pour une fenêtre de synthèse et un recouvrement donné, on détermine une fenêtre d'analyse qui permet d'obtenir une reconstruction parfaite du signal à coder (en l'absence de quantification).

Une fenêtre classiquement utilisée en codage par transformée est une fenêtre de type sinusoïdale identique à la fois à l'analyse et à la synthèse. Dans cette configuration, le délai algorithmique minimum introduit par le système de codage est de 2M/Fs secondes.

Pour réduire ce délai, on peut imposer des zéros en début de fenêtre de synthèse et en fin de fenêtre d'analyse. Comme le résultat d'une multiplication du signal par « 0 » est connu à l'avance, on peut décaler le rythme de trames par rapport à la position des fenêtres. Ces fenêtres, symétriques, sont par exemple composées :

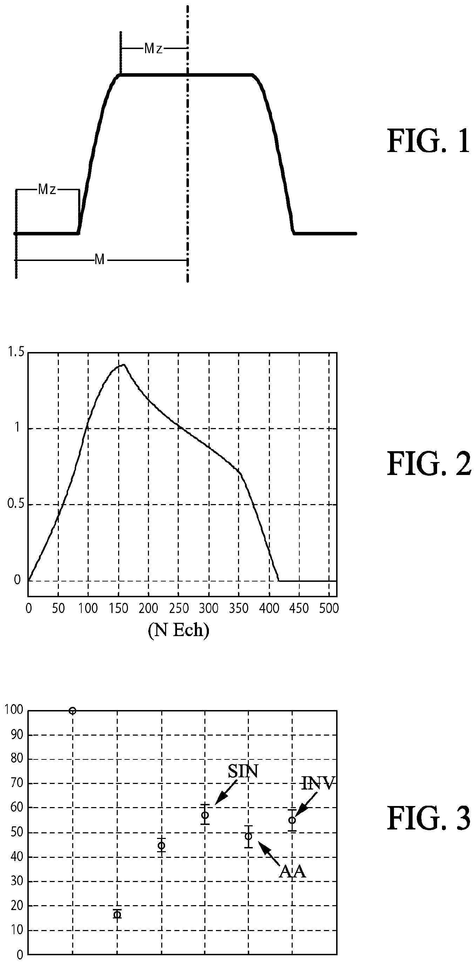

- d'un certain nombre de zéros *Mz* qui s'étendent sur un intervalle correspondant à la moitié du retard algorithmique que l'on veut sauvegarder,
- d'une montée en sinus de longueur *M-2Mz,*
- d'une section de 2*Mz* valeurs à 1,
- la deuxième moitié de la fenêtre étant enfin le symétrique de la première comme illustré sur la figure 1 ci-annexée.

Ces fenêtres ont un délai algorithmique de (2M-2Mz)/Fs secondes et permettent ainsi de réduire le retard de 2Mz/Fs secondes.

Toutefois, une telle technique, si elle permet de réduire le délai, tend, lorsque la réduction du délai augmente, à ressembler à une fenêtre rectangulaire. Une telle forme de fenêtre est peu sélective en fréquences, et fait finalement baisser de manière drastique la qualité audio du signal encodé. De plus, elle contraint fortement la fenêtre car 4Mz échantillons sont imposés lors de sa construction. On ne dispose pas de beaucoup de degrés de liberté pour proposer des fenêtres efficaces pour le codage, notamment pour offrir une sélectivité fréquentielle importante.

Il a été proposé dans le document WO-2009/081003 d'utiliser des fenêtres asymétriques pour pallier ce problème. Ces fenêtres, à l'analyse, sont composées de 0 uniquement sur la fin de la fenêtre d'analyse. Afin de limiter l'espace de stockage requis, la fenêtre de synthèse est choisie comme la retournée temporelle de la fenêtre d'analyse. Cette technique permet notamment de réduire le délai à l'encodage, ainsi que le délai au décodage. Pour un nombre de zéros total Mz deux fois moins important que celui des fenêtres symétriques présentées précédemment, le gain de délai est le même. Compte tenu du nombre réduit de zéros, la sélectivité fréquentielle de telles fenêtres asymétriques est supérieure à celle des fenêtres symétriques. La qualité audio du signal décodé s'en trouve améliorée.

Plus particulièrement, le document WO-2009/081003 présente une fenêtre d'analyse ha(n) composée de deux parties ha1 et ha2 à partir d'une fenêtre initiale h(n) donnée par :

$$h(n) = \sin\left[\frac{x}{2M - M_z}\left(n + \frac{1}{2}\right)\right]$$

pour $0 \leq n < 2M - M_z$

et $h(n) = 0$ sinon (c'est-à-dire pour $2M - M_z \leq n < 2M$).

et d'un facteur correctif $\Delta(n)$ permettant d'avoir la condition de reconstruction parfaite, donné par :

$$\Delta(n) = \sqrt{h(n)h(2M - 1 - n) + h(n + M)h(M - 1 - n)}$$

La fenêtre d'analyse $h_a$ est donné par :

$$h_{a1}(n + M) = h(n + M)/\Delta(n) \quad \text{et} \quad h_{a2}(n) = h(n)/\Delta(n)$$

pour $0 \leq n < M$

La fenêtre de synthèse $h_s(n)$ est la retournée temporelle de la fenêtre d'analyse :

$$h_s(2M - 1 - n) = h_a(n),$$

pour $0 \leq n < 2M$

De telles fenêtres sont, pour un même gain de délai, de meilleure qualité que des fenêtres symétriques du fait de leur meilleure sélectivité fréquentielle.

Toutefois, quand bien même la technique antérieure est avantageuse et propose une amélioration de la qualité par rapport aux techniques précédente, lorsqu'une solution est cherchée avec un gain de délai plus important, avec par exemple un nombre de zéros Mz supérieur à M/4 (où M est une durée de trame), on observe, en appliquant de telles fenêtres, une dégradation audible qui peut s'expliquer notamment par le fait qu'une portion de la fenêtre prend des valeurs élevées, bien supérieures à 1, comme illustré sur la figure 2. Or, il est généralement préférable, en traitement de signal numérique, d'utiliser des pondérations à valeurs inférieures à 1 en valeur absolue du fait de l'implémentation en virgule fixe.

La présente invention vient améliorer la situation.

Elle propose à cet effet un procédé de codage d'un signal numérique constitué de blocs successifs d'échantillons, le codage étant du type par transformée avec recouvrement et comprenant, à l'analyse, l'application d'une fenêtre de pondération sur deux blocs de $M$ échantillons successifs. En particulier, la fenêtre de pondération précitée est asymétrique et comporte quatre portions distinctes s'étendant successivement sur les deux blocs, avec :

- une première portion, croissante sur un premier intervalle d'échantillons,
- une deuxième portion, constante à une valeur de 1 sur un deuxième intervalle,
- une troisième portion, décroissante sur un troisième intervalle, et
- une quatrième portion, constante à une valeur de 0 sur un quatrième intervalle.

Comme on le verra plus loin, selon l'un des avantages que procure l'invention, la constance de la fenêtre à 1 pendant le deuxième intervalle permet de réduire la complexité de l'utilisation des fenêtres de l'art antérieur telles que celles décrites dans le document WO-2009/081003, tout en conservant ses avantages de faible retard et en améliorant en outre la qualité du rendu audio, comme on le verra plus loin en référence à la figure 3.

Par ailleurs, il est avantageux que les premier, deuxième et troisième intervalles soient calculés au moins en fonction de la durée du quatrième intervalle (nombre de 0 en fin de fenêtre), qui fixe le retard précité, lequel peut avantageusement être ramené à un retard algorithmique comme on le verra dans les exemples de réalisation ci-après. De même, les fronts de montée et de descente des portions respectivement croissante et décroissante peuvent être optimisés en fonction notamment de la durée du quatrième intervalle. Le quatrième intervalle (noté Mz ci-après) s'exprime lui-même en fonction du nombre d'échantillons M par bloc, et bien entendu en fonction du retard maximal souhaité.

La succession des fenêtres d'analyse présente des caractéristiques similaires avec celle décrite dans le document précité WO-2009/081003. En particulier, deux blocs d'échantillons de même taille 2M, étant pondérés respectivement par une première et une deuxième fenêtre d'analyse, le front montant de la deuxième fenêtre peut être différent du front descendant de la première fenêtre retournée temporellement. Ces fronts ne sont donc pas symétriques *a priori*.

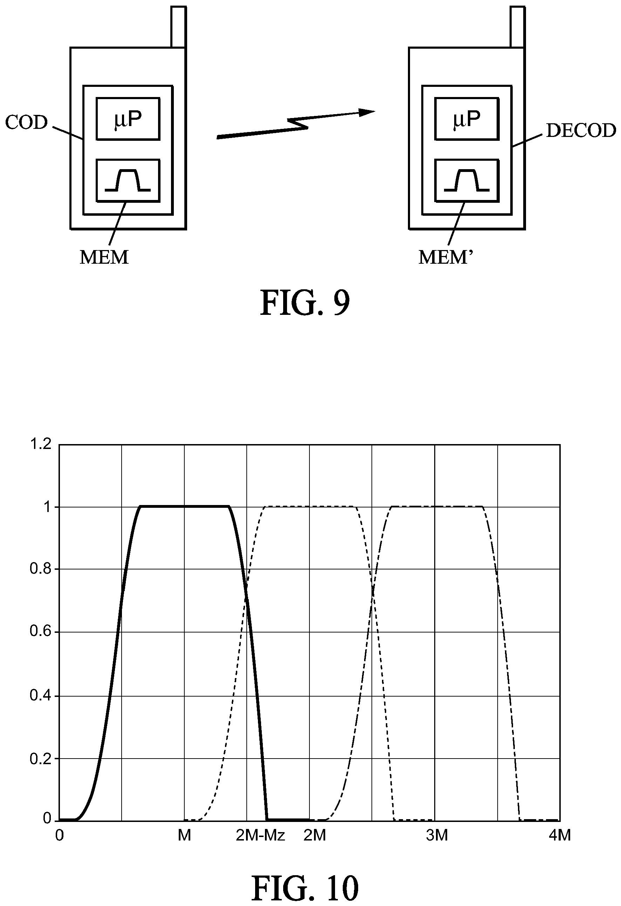

Par ailleurs, dans la mise en oeuvre de l'invention, au codage, plusieurs mêmes fenêtres d'analyse ayant les caractéristiques précitées (montée, constance à 1, descente et constance à 0) peuvent être appliquées successivement à une pluralité de blocs successifs de 2M échantillons, se recouvrant de M échantillons, comme illustré sur la figure 10. En termes génériques, le procédé de l'invention comporte alors l'application d'une pluralité de fenêtres successives, asymétriques et comportant les quatre portions précitées, à une succession de paires de blocs. Ainsi, comme dans le document WO-2009/081003, on ne prévoit pas, ici encore, de fenêtre de transition particulière lorsque la fenêtre asymétrique est appliquée.

La fenêtre varie sur le premier intervalle, noté $R_1$, comme une fonction $w_1$ de type :

$$w_1(n) = \frac{W_1(n)}{\Delta_n(n)}, \text{ avec } W_1(n) = \sin\left(\frac{\pi}{2}\frac{n+1}{R_1}\right)^{C_1}$$

et : $\Delta_n(n) = \sqrt{h_i(n).h_i(2M-n-1) + h_i(n+M).h_i(M-n-1)}$, $n \in [0 ; M\text{-}1]$ avec $C_1$ et $R_1$, des constantes supérieures à 0, $h_i$ étant une fenêtre d'initialisation.

Par optimisation par exemple, on trouve que le terme $C_1$ peut être compris entre 3 et 5, pour une gamme de retards de l'ordre de 15 à 30 ms. Dans un exemple de réalisation particulier, $C_1 = 4,8425$. Le premier intervalle, noté $R_1$, est, dans cet exemple de réalisation, de durée donnée par : $R_1 = \left\lfloor \frac{2M \times 404}{1280} + 0,5 \right\rfloor$, où $M$ correspond à la durée d'un bloc,

la notation $\lfloor x \rfloor$ désignant l'entier plus petit ou égal à x et le plus proche de x.

Pour ce qui concerne la deuxième portion de la fenêtre, cette dernière varie sur le troisième intervalle, noté $R_2$, comme une fonction $w_3$ de type :

$$w_3(n) = \frac{W_3(n)}{\Delta_n(n)}, \text{ avec } W_3(n) = \cos\left(\frac{\pi}{2}\frac{n}{R_2}\right)^{C_2},$$

et : $\Delta_n(n) = \sqrt{h_i(n).h_i(2M-n-1) + h_i(n+M).h_i(M-n-1)}$, $n \in [0; M\text{-}1]$ avec $C_2$ et $R_2$, des constantes supérieures à 0.

D'après des essais d'optimisation réalisés, le terme $C_2$ est préférentiellement compris entre 0,85 et 1.05 et dans l'exemple de réalisation particulier, $C_2 = 0,9659$.

Le troisième intervalle, noté $R_2$, est dans cet exemple de réalisation de durée préférentielle donnée par :

$R_2 = \left\lfloor \frac{2M \times 196}{1280} + 0,5 \right\rfloor$, où M correspond à la durée d'un bloc,

la notation $\lfloor x \rfloor$ désignant l'entier plus petit ou égal à x et le plus proche de x.

Dans cet exemple de réalisation, le quatrième intervalle, noté $M_z$, est choisi initialement tel qu'il est de durée donnée par $M_z = \left\lceil \frac{2M \times 7}{40} \right\rceil$ où la notation $\lceil x \rceil$ désigne l'entier plus grand ou égal à x et le plus proche de x, $M$ correspondant à la durée d'un bloc.

Bien entendu, d'autres retards peuvent être implémentés et ainsi d'autres durées du quatrième intervalle Mz peuvent être prévues. Le tableau 1 donné dans les exemples de réalisation détaillés ci-après indique des valeurs des paramètres $C_1$, $C_2$, et des intervalles $R_1$, $R_2$, pour différentes valeurs de retards et donc pour différentes durées de quatrième intervalle Mz.

Ainsi, le procédé peut avantageusement comporter une étape préalable d'optimisation de la forme de la fenêtre, cette optimisation étant basée sur au moins une estimation de fonction de coût, pour parvenir aux paramètres optimums $C_1$, $C_2$, et/ou encore $R_1$, $R_2$ présentés ci-avant.

Globalement, il est avantageux que le nombre total de « 1 » dans la fenêtre soit environ deux fois plus grand que le nombre de 0, d'après les optimisations réalisées, notamment pour une bonne qualité de rendu audio.

Ainsi, dans un autre exemple de réalisation particulier, le premier intervalle, noté $R_1$, est par exemple de durée donnée par :

$R_1 = \lfloor M - M_z + 1 + 0,5 \rfloor$, où $M$ correspond à la durée d'un bloc, et $M_z$ correspond à la durée du quatrième intervalle.

Dans cet exemple, le troisième intervalle $R_2$ peut être de durée donnée par :

$R_2 = \lfloor M - 2M_z + 1 + 0,5$, où $M$ correspond à la durée d'un bloc, et $M_z$ correspond à la durée du quatrième intervalle.

Le tableau 2 donné dans les exemples de réalisation détaillés ci-après indique des valeurs des paramètres $C_1$ et $C_2$, lorsque les intervalles $R_1$ et $R_2$ ont été ainsi fixés, pour différentes valeurs de retards et donc pour différentes durées de quatrième intervalle Mz.

Ainsi, l'invention propose, sur un principe de fenêtre asymétrique à reconstruction parfaite avec un nombre choisi de zéros du type présenté dans le document WO-2009/081003, l'utilisation de fenêtres optimisées, d'analyse et de synthèse, lesquelles permettent d'avoir un bon rendu sonore, tout en assurant une mise en oeuvre efficace. On a illustré sur la figure 3 une comparaison des performances en termes de qualité audio entre une fenêtre selon l'invention (référence INV), une fenêtre selon le document WO-2009/081003 (référence AA) et une fenêtre sinusoïdale classique (SIN) pour un délai à 26 ms. Les autres points, sans référence, concernent d'autres techniques de l'état de l'art. Il apparaît que l'invention permet de conserver une qualité audio équivalente à celle atteinte avec des fenêtres classiques (SIN), tout en offrant un gain de délai comparable à celui atteint par la mise en oeuvre décrite dans le document WO-2009/081003. On retient alors dans la description ci-après, comme critère d'appréciation, la qualité perceptuelle, une erreur de reconstruction de la transformée restant négligeable, perceptiblement, par rapport à un seuil de perception prédéterminé.

La présente invention vise un procédé de décodage d'un signal numérique, codé par la mise en oeuvre du procédé ci-avant, le décodage étant du type par transformée avec recouvrement et comprenant, à la synthèse, l'application d'une fenêtre de pondération sur deux blocs d'échantillons codés successifs. En particulier, la fenêtre de pondération, à la synthèse, est identique à la fenêtre d'analyse utilisée au codage, retournée temporellement, par exemple pour assurer une propriété de reconstruction parfaite, comme on le verra plus loin.

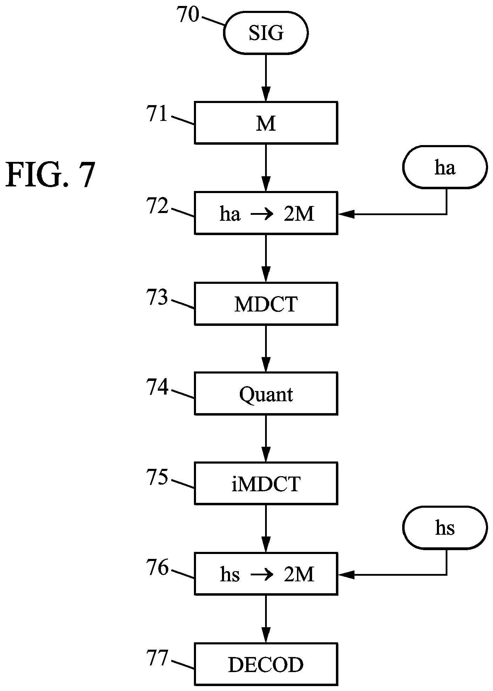

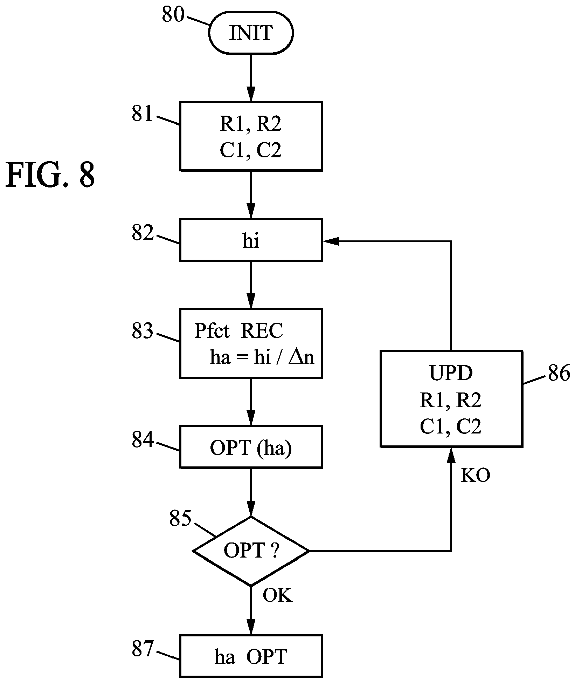

La présente invention vise aussi un programme informatique destiné à être stocké en mémoire d'un dispositif de codage ou de décodage, et comportant en particulier des instructions pour la mise en oeuvre du procédé de codage ci-avant ou du procédé de décodage précité, lorsque les instructions sont exécutées par un processeur du dispositif. En particulier, il peut s'agir d'un programme informatique comportant une première partie propre au codage et une deuxième partie propre au décodage. La figure 7 commentée plus loin est un exemple d'organigramme de l'algorithme général d'un tel programme et la figure 8 illustre des étapes préalables que peut comporter, dans une réalisation particulière, l'algorithme de ce programme, en particulier si ce programme comporte des instructions pour la construction préalable des fenêtres d'analyse et de synthèse qu'utilisent les procédés de codage/décodage au sens de l'invention.

Comme représenté schématiquement sur la figure 9, la présente invention vise aussi un dispositif de codage COD d'un signal, comportant des moyens de stockage MEM et/ou de calcul $\mu$P de données d'une fenêtre de pondération, d'analyse, pour la mise en oeuvre du procédé de codage selon l'invention. De même, la présente invention vise aussi un dispositif de décodage DECOD d'un signal, comportant des moyens de stockage MEM' et/ou de calcul $\mu$P de données d'une fenêtre de pondération, de synthèse, pour la mise en oeuvre du procédé de décodage selon l'invention. On peut en particulier, pour le codage comme pour le décodage, partir de valeurs pré-initialisées de fenêtres d'analyse et/ou synthèse (stockées en mémoires MEM et/ou MEM'), et possiblement optimiser ces valeurs à la volée (par la mise en oeuvre des moyens de calculs $\mu$P).

D'autres avantages et caractéristiques de l'invention apparaîtront à la lecture de la description détaillée, donnée ci-après à titre d'exemples de réalisation non limitatifs, et des dessins annexés sur lesquels :

- la figure 1 illustre l'allure d'une fenêtre symétrique classique à faible délai, comportant des zéros en début et en fin de fenêtre,
- la figure 2 illustre l'allure d'une fenêtre asymétrique telle que décrite dans le document WO-2009/081003, avec un gain de délai de 15 ms pour une trame 2M de 40 ms,
- la figure 3 illustre une comparaison de la qualité audio entre une fenêtre au sens de l'invention INV, une fenêtre sinusoïdale SIN selon la figure 1, et une fenêtre AA selon la figure 2, pour un délai de 26 ms,
- la figure 4 illustre un premier exemple de fenêtre d'initialisation $h_i$ pour la construction d'une fenêtre d'analyse au sens de l'invention,
- la figure 5 illustre un deuxième exemple de fenêtre d'initialisation $h_i$ pour la construction d'une fenêtre d'analyse au sens de l'invention,
- la figure 6 illustre un exemple de fenêtre d'analyse au sens de l'invention, obtenue à partir d'une fenêtre d'initialisation du type représentée sur la figure 5,
- la figure 7 présente schématiquement les étapes d'un exemple de procédé de codage/décodage par transformée, pour illustrer le contexte de la présente invention,
- la figure 8 présente schématiquement les étapes d'un exemple de construction des fenêtres d'analyse et de synthèse pour une mise en oeuvre du procédé au sens de l'invention,

- la figure 9 présente schématiquement des dispositifs de codage et de décodage pour la mise en oeuvre de l'invention,
- la figure 10 illustre une succession de fenêtres d'analyse au sens de l'invention, appliquées avec recouvrement.

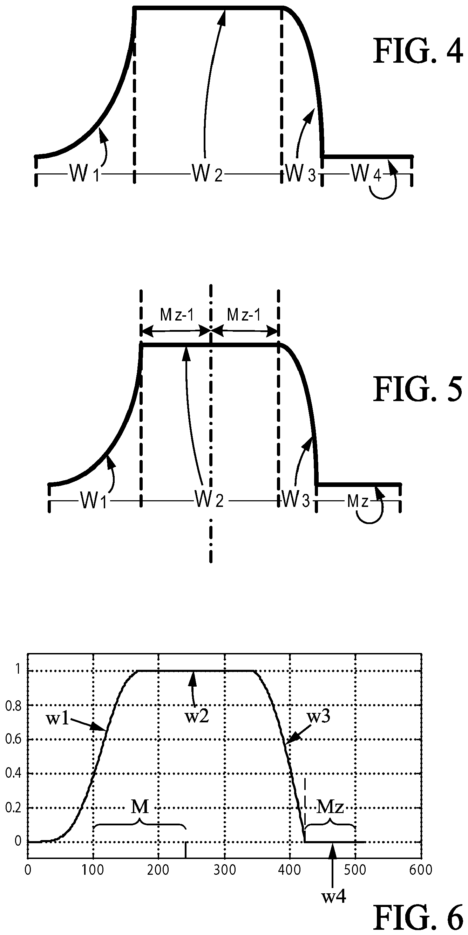

On se réfère tout d'abord à la figure 7 pour décrire, en tant que cadre général de la mise en oeuvre de l'invention, un procédé de codage/décodage d'un signal numérique (donné à l'étape 70), par transformée avec recouvrement. Le procédé comprend une étape 71 de découpage du signal audionumérique en trames de longueur $M$. Ensuite, chaque trame est groupée avec la précédente, ce qui correspond à un recouvrement de 50 %. A l'étape suivante 72, une fenêtre d'analyse $h_a$ est appliquée à cet ensemble de deux trames. On a illustré sur la figure 6 un exemple de fenêtre d'analyse $h_a$ au sens de l'invention (amplitude de 0 à 1 en fonction du nombre d'échantillons « Nb Ech »). On relèvera que la fenêtre d'analyse $h_a$ se termine par Mz valeurs à 0 et est de longueur totale 2M.

L'étape suivante 73 consiste à appliquer une transformée, par exemple de type MDCT, au bloc de deux trames ainsi pondéré par la fenêtre $h_a$, puis à quantifier (étape 74) les valeurs dans le domaine transformé.

Au décodage, une transformée inverse permet, à l'étape 75, de reconvertir les valeurs dans le domaine temporel. Si la transformée au codage est par exemple de type MDCT, une transformée inverse iMDCT peut être appliquée au décodage.

A l'étape 76, pour assurer une condition de reconstruction parfaite, une fenêtre de synthèse $h_s$ est appliquée aux deux trames décodées. Comme décrit dans le document WO-2009/081003, cette condition impose un facteur correctif $1/\Delta_n$ (décrit plus en détail ci-après) appliqué à une fenêtre d'initialisation $h_i$ pour obtenir la fenêtre d'analyse $h_a$. La fenêtre de synthèse $h_s$ se présente comme la retournée temporelle de la fenêtre d'analyse $h_a$, avec :

$$h_s(n) = h_a(2M - n - 1)$$

A l'étape 77, les blocs qui se recouvrent sont sommés, pour délivrer finalement le signal décodé, en assurant une reconstruction parfaite.

On se réfère à nouveau à la figure 6, pour décrire plus en détails l'allure de la fenêtre d'analyse $h_a$ utilisée dans un tel procédé, en particulier au codage. La fenêtre d'analyse est constituée de quatre segments distincts w1, w2, w3, w4. Il en est de même pour la fenêtre de synthèse $h_s$ qui se présente comme la retournée temporelle de la fenêtre d'analyse.

Sur un premier intervalle noté ci-après $R_1$, la fenêtre d'analyse varie comme une fonction $w_1$ de type :

$$w_1(n) = \frac{W_1(n)}{\Delta_n(n)}, \text{ avec } W_1(n) = \sin\left(\frac{\pi}{2}\frac{n+1}{R_1}\right)^{C_1},$$

et:

$$\Delta_n(n) = \sqrt{h_i(n).h_i(2M-n-1) + h_i(n+M).h_i(M-n-1)}, \ n \in [0; \ M-1]$$

Ensuite, la fenêtre d'analyse est constante et vaut w2=1 sur un deuxième intervalle.

Sur un troisième intervalle noté ci-après $R_2$, la fenêtre varie comme une fonction $w_3$ de type :

$$w_3(n) = \frac{W_3(n)}{\Delta_n(n)}, \text{ avec } W_3(n) = \cos\left(\frac{\pi}{2}\frac{n}{R_2}\right)^{C_2},$$

et :

$$\Delta_n(n) = \sqrt{h_i(n).h_i(2M-n-1) + h_i(n+M).h_i(M-n-1)},$$

avec :

$$n \in [0; \ M - 1]$$

Enfin, sur un quatrième intervalle Mz, la fenêtre d'analyse est constante et vaut w4=0.

On montre ci-après que, par rapport à l'art antérieur WO-2009/081003, la forme de telles fenêtres permet d'assurer une qualité audio optimale pour un gain de délai important (pouvant aller par exemple jusqu'à 40 %). L'utilisation de telles fenêtres (de variations générales : croissante, constante à 1, décroissante et constante à 0) ne se limite pas à un type de transformée MDCT. Elles peuvent aussi être utilisées par exemple dans le cas où le codage ne concerne uniquement qu'une partie seulement du signal à coder (par exemple une partie de la bande audio seulement, par exemple pour traiter une erreur de codage par rapport à une autre technique de codage, ou autres).

On décrit maintenant en référence à la figure 8 comment est obtenue la fenêtre $h_a$ utilisée dans un procédé tel que décrit ci-avant en référence à la figure 7.

Suite à une étape d'initialisation 80, on définit des paramètres d'initialisation $R_2$, $C_1$ et $C_2$ à l'étape 81. A l'étape suivante 82, on calcule à partir de ces paramètres d'initialisation une fenêtre d'initialisation $h_i$. Comme illustré sur les figures 4 et 5, cette fenêtre d'initialisation $hi$ est constituée de quatre segments $W_1$, $W_2$, $W_3$, $W_4$.

Le premier segment $W_1$ de longueur $R_1$ est défini par l'équation :

$$W_1(n_1) = \sin\left(\frac{\pi}{2} \frac{n_1 + 1}{R_1}\right)^{C_1} , \ n_1 \in [0; \ R_1 - 1]$$

où $C_1$ est une constante >0.

Le deuxième segment $W_2$ de longueur $L=2M-R_1-R_2-M_z$ est composé de valeurs à 1.

Le troisième segment $W_3$ de longueur $R_2$ est défini par l'équation :

$$W_3(n_2) = \cos\left(\frac{\pi}{2} \frac{n_2}{R_2}\right)^{C_2} , \ n_2 \in [0; \ R_2 - 1]$$

où $C_2$ est une constante >0.

Le quatrième segment $W_4$ de longueur $M_z$ est composé de valeurs toutes à 0.

La fenêtre d'initialisation $h_i(n)$ est donc donnée par :

$$h_i(n) = \begin{cases} W_1(n) & \text{pour } n \in [0; \ R_1 - 1] \\ 1 & \text{pour } n \in [R_1; \ 2M - R_2 - M_z - 1] \\ W_3(n - 2M + R_2 + M_z) & \text{pour } n \in [2M - R_2 - M_z; \ 2M - M_z - 1] \\ 0 & \text{pour } n \in [2M - M_z; \ 2M - 1] \end{cases}$$

A l'étape 83, on applique à la fenêtre d'initialisation $h_i$, un facteur $1/\Delta_n$ qui permet d'assurer une condition de reconstruction parfaite, et ce en supposant que la fenêtre de synthèse est la retournée temporelle de la fenêtre d'analyse et que la transformée au décodage sera duale (par exemple une transformée iMDCT, si une transformée MDCT a été appliquée au codage).

Le terme $\Delta_n$ est donné par :

$$\Delta_n(n) = \Delta_n(n + M) = \sqrt{h_i(n).h_i(2M - n - 1) + h_i(n + M).h_i(M - n - 1)}$$

$$n \in [0; \ M - 1]$$

La fenêtre d'analyse $h_a$ à reconstruction parfaite est alors donnée par

$$h_a(n) = \frac{h_i(n)}{\Delta_n(n)} , \ n \in [0; \ 2M - 1]$$

On relèvera que les valeurs strictement à "1" ne nécessitent aucune multiplication de pondération. Ainsi, le gain attendu en complexité est important par rapport à l'état de l'art, comme le montre le tableau ci-après, selon un autre avantage que procure l'invention.

| Fenêtre (512 points) | Nombre de multiplications | Gain |
|---|---|---|
| Fenêtre SIN de la figure 1 | 512 | 0% |
| Fenêtre AA de la figure 2 | 416 | 19% |
| Fenêtre INV de la figure 6 | 224 | 56% |

Ainsi, pour un gain de délai donné (un nombre Mz de zéros donné), il existe une combinaison optimale des quatre paramètres $R_1$, $R_2$, $C_1$, $C_2$ définissant la forme précise des fenêtres d'analyse et de synthèse permettant d'avoir la meilleure qualité audio possible. Ces paramètres peuvent être obtenus par optimisation à itérations successives, comme décrit plus loin en référence à nouveau à la figure 8.

Par exemple, un gain de délai de 35 % (correspondant à 14 ms pour des trames de 40 ms dans l'exemple décrit ici), correspond simplement à un délai algorithmique du codeur. Ce délai, de 26 ms dans l'exemple décrit, impose un nombre de zéros $M_z$ donné par :

$$M_z = \left\lceil \frac{2M \times 7}{40} \right\rceil$$

où $\lceil x \rceil$ dénote l'entier plus grand ou égal à x le plus proche de x. On trouve alors Mz = 14ms, pour M = 40ms.

Avec ce choix, les valeurs des paramètres des fenêtres d'analyse et de synthèse peuvent être par exemple données par :

$$R_1 = \left\lfloor \frac{2M \times 404}{1280} + 0.5 \right\rfloor$$

$$R_2 = \left\lfloor \frac{2M \times 196}{1280} + 0.5 \right\rfloor$$

$$C_1 = 4.8425$$

$$C_2 = 0.9659$$

où $\lfloor x \rfloor$ dénote l'entier plus petit ou égal à x le plus proche de x.

Une telle réalisation correspond à la fenêtre d'initialisation représentée sur la figure 4.

Un autre exemple d'approche permet de réduire le nombre de paramètres de la fenêtre d'initialisation à rechercher. Cette approche consiste à considérer que le nombre de « 1 » dans la fenêtre $h_i$ doit être le double du nombre de « 0 » et que l'axe de symétrie de la fenêtre $h_i$ correspond au milieu du segment $W_2$, comme illustré sur la figure 5. Dans ces conditions, les valeurs des intervalles $R_2$ et $R_1$ dépendent uniquement de l'étendu de l'intervalle Mz (c'est-à-dire du nombre choisi de « 0 » à la fin de la fenêtre d'initialisation).

Dans ces conditions :

$$M_z = \left\lceil \frac{2M \times \frac{C_{delay}}{2}}{FL} \right\rceil$$

$$R_2 = \lfloor M - 2M_z + 1 + 0.5 \rfloor$$

$$R_1 = \lfloor M - M_z + 1 + 0.5 \rfloor$$

où $G_{delay}$ est le gain souhaité sur le délai, en ms, FL est la longueur de la trame 2M en ms (la fréquence d'échantillonnage étant donnée par Fs = 2M/FL x1000, si l'on compte en millisecondes ou « ms »).

Ensuite, on cherche à l'étape 84 de la figure 8 à déterminer les constantes $C_1$ et $C_2$ (et éventuellement $R_1$ et $R_2$), par exemple par la mise en oeuvre d'une optimisation itérative (comme par exemple la technique dite « des gradients »).

En partant par exemple à l'étape 81 d'un choix de paramètres initiaux pour les valeurs de $R_1$ ; $R_2$; $C_1$ et $C_2$ respectivement de 2Mz ; Mz ; 1 et 1, on calcule à l'étape 84 une fonction coût appliquée à :

- la fenêtre d'analyse découlant de la fenêtre d'initialisation ayant une forme du type présenté ci-avant, et
- sa duale de synthèse, assurant une reconstruction parfaite.

La fonction coût peut être composée d'un ensemble de critère à vérifier au test 85. On peut citer par exemple et de manière non exhaustive :

- l'analyse de la dérivée première de la fenêtre :

$$D1 = \log 10 \left( \frac{1}{2M} \sum_{n=0}^{n=2M-1} D'(n) \right)$$

avec

$$D'(n) = \begin{cases} |W(0)| & \text{si } n = 0 \\ |W(n+1) - W(n)| & \text{si } 0 < n < 2M-1 \\ |W(2M-1)| & \text{si } n = 2M-1 \end{cases}$$

- l'analyse de la dérivée seconde de la fenêtre :

$$D2 = \log 10 \left( \frac{1}{2M} \sum_{n=0}^{n=2M-1} D''(n) \right)$$

avec

$$D''(n) = \begin{cases} D'(0) & \text{si } n = 0 \\ |D'(n+1) - D'(n)| & \text{si } 0 < n < 2M-1 \\ |D'(2M-1)| & \text{si } n = 2M-1 \end{cases}$$

- la recherche de gain de codage tel que défini par exemple dans le document WO-2009/081003,
- la maximisation du rapport signal à bruit « SNR », exprimé en logarithme entre un signal non codé et l'erreur introduite par le codage, pour un échantillon audio donné en appliquant à la fois la fenêtre d'analyse et la fenêtre de synthèse au sens de l'invention.

Au test 85, on peut vérifier si les critères de fin d'optimisation son atteints (valeur de fonction coût, variation de la valeur des paramètres, ou autres). Le cas échéant (flèche OK), les valeurs de paramètres optimisés sont trouvées à l'étape de fin 87. Sinon, dans le cas contraire (flèche KO), les valeurs de $R_1$, $R_2$, $C_1$ et $C_2$ sont modifiées de manière à réduire la fonction de coût.

Ainsi, en partant d'un choix de paramètres initiaux $R_1$ ; $R_2$ ; $C_1$ et $C_2$ respectivement à 2Mz ; Mz ; 1 et 1, on trouve, après optimisation :

$$R_1 = \left\lfloor \frac{2M \times 404}{1280} + 0.5 \right\rfloor$$

$$R_2 = \left\lfloor \frac{2M \times 196}{1280} + 0.5 \right\rfloor$$

$$C_1 = 4.8425$$

$$C_2 = 0.9659$$

si l'on prend l'option d'optimiser à la fois ces quatre paramètres,
ou, alternativement :

- $C_1$ avec une valeur proche de 5, et
- $C_2$ avec une valeur proche de 1,

si l'on prend l'option de n'optimiser que les deux paramètres $C_1$ et $C_2$.

On peut donc, dans cette deuxième option, limiter la recherche de valeurs optimale à $C_1$ et $C_2$ dans le cas où l'on considère que le nombre de 1 est le double du nombre de 0 et que l'axe de symétrie de la fenêtre correspond au milieu du segment $W_2$ comme illustré sur la figure 5.

Il est à noter qu'avec la première option précitée (en optimisant les quatre paramètres à la fois), pour un retard de 28ms (au lieu de 26ms comme précédemment), on trouve $C_1$=4,1582 et $C_2$=0,9181 avec cette technique d'optimisation.

Plus généralement, le tableau 1 ci-dessous présente un ensemble de paramètres $R_1$, $R_2$, $C_1$ et $C_2$ optimisés, selon différentes options de retard et donc de nombre d'échantillons à « 0 » (Mz). Le nombre d'échantillons par trame M est donné pour une fréquence d'échantillonnage à 48000 Hz et des trames de 20 ms :

**Tableau 1** : optimisation des quatre paramètres à la fois $R_1$, $C_1$, $R_2$, $C_2$

| Retard (ms) | M | Mz | $R_1$ | $R_2$ | $C_1$ | $C_2$ |
|---|---|---|---|---|---|---|
| 26 | 960 | 336 | 404*M/640=606 | 196*M/640=294 | 4,8425 | 0,9659 |
| 28 | 960 | 288 | M-Mz=672 | M-2*Mz=384 | 4,1582 | 0,9181 |
| 30 | 960 | 240 | 480*M/640=720 | 320*M/640=480 | 3,8945 | 0,8502 |
| 26 | 960 | 336 | 398*M/640=597 | 190*M/640=285 | 5,0304 | 0,9777 |

Les données de ce tableau s'expriment en particulier en fonction du nombre d'échantillons à « 0 » dans le quatrième intervalle Mz, comme suit :

| Retard (ms) | M | Mz | $R_1$ | $R_2$ | $C_1$ | $C_2$ |
|---|---|---|---|---|---|---|
| 26 | 960 | 336 | 404*(20/7)*Mz/640=606 | 196*(20/7)*Mz/640=294 | 4,8425 | 0,9659 |
| 28 | 960 | 288 | M-Mz=672 | M-2*Mz=384 | 4,1582 | 0,9181 |
| 30 | 960 | 240 | M-Mz=720 | M-2*Mz =480 | 3,8945 | 0,8502 |
| 26 | 960 | 336 | 398*(20/7)*Mz/640=597 | 190*(20/7)*Mz/640=285 | 5,0304 | 0,9777 |

Le tableau 2 ci-dessous présente un ensemble de paramètres $C_1$ et $C_2$ optimisés, selon la deuxième option précitée, en fixant les intervalles $R_1$ et $R_2$ en fonction du nombre de zéros Mz. Le nombre d'échantillons par trame M est donné pour une fréquence d'échantillonnage à 48000 Hz et des trames de 20 ms :

**Tableau 2** : optimisation des deux paramètres $C_1$ et $C_2$, après fixation des intervalles $R_1$ et $R_2$

| Retard (ms) | M | Mz | $R_1$=M-Mz+1 | $R_2$=M-2*Mz+1 | $C_1$ | $C_2$ |
|---|---|---|---|---|---|---|
| 26 | 960 | 336 | 625 | 289 | 4,4265 | 1,0256 |
| 28 | 960 | 288 | 673 | 385 | 4,1406 | 0,9163 |
| 30 | 960 | 240 | 721 | 481 | 3,7382 | 0,8699 |

Bien entendu, la présente invention ne se limite pas à la forme de réalisation décrite ci-avant à titre d'exemple ; elle s'étend à d'autres variantes.

Par exemple, la méthode d'optimisation par itération peut être comme décrit ci-avant une méthode de type dit « des gradients » mais d'autres variantes sont, bien entendu, possibles. On peut aussi par exemple, au sein du processus d'optimisation, fixer le maximum de la fenêtre $h_a$ à 1, de manière à traiter les échantillons sonores avec un poids relativement constant.

De façon plus générale, les valeurs des fenêtres d'analyse et de synthèse peuvent être déterminées préalablement (par optimisation comme décrit ci-avant), puis stockées en dur dans une mémoire d'un dispositif de codage ou de décodage, pour être utilisées dans un procédé de codage ou de décodage. Dans une variante, il est possible de définir des fenêtres d'initialisation, les stocker en mémoire des dispositifs précités, et de les optimiser ensuite selon par exemple des conditions de communication.

## Revendications

1. Procédé de codage d'un signal numérique, ledit signal étant constitué de blocs successifs d'échantillons, le codage étant du type par transformée avec recouvrement et comprenant, à l'analyse, l'application d'une fenêtre de pondération sur deux blocs de $M$ échantillons successifs, ladite fenêtre de pondération étant asymétrique et comportant quatre portions distinctes s'étendant successivement sur lesdits deux blocs, avec :

   - une première portion ($w_1$), croissante sur un premier intervalle d'échantillons,
   - une deuxième portion ($w_2$), constante à une valeur de 1 sur un deuxième intervalle,
   - une troisième portion ($w_3$), décroissante sur un troisième intervalle, et
   - une quatrième portion ($w_4$), constante à une valeur de 0 sur un quatrième intervalle.

   **caractérisé en ce que** la fenêtre varie sur le premier intervalle, noté comme une fonction $w_1$ de type :

   $$w_1(n) = \frac{W_1(n)}{\Delta_n(n)}, \text{ avec } W_1(n) = \sin\left(\frac{\pi}{2}\frac{n+1}{R_1}\right)^{C_1}$$

   et :

   $$\Delta_n(n) = \sqrt{h_i(n).h_i(2M-n-1) + h_i(n+M).h_i(M-n-1)}, \ n \in [0;\ M-1],$$

   avec $C_1$ et $R_1$, des constantes supérieures à 0, $h_i$ étant une fenêtre d'initialisation, et **en ce que** la fenêtre varie sur le troisième intervalle, noté $R_2$, comme une fonction $w_3$ de type :

   $$w_3(n) = \frac{W_3(n)}{\Delta_n(n)}, \text{ avec } W_3(n) = \cos\left(\frac{\pi}{2}\frac{n}{R_2}\right)^{C_2},$$

   avec $C_2$ et $R_2$, des constantes supérieures à 0.

2. Procédé selon la revendication 1, **caractérisé en ce que** les premier, deuxième et troisième intervalles sont calculés au moins en fonction du quatrième intervalle (Mz).

**3.** Procédé selon la revendication 1, **caractérisé en ce que** le terme $C_1$ est compris entre 3 et 5.

**4.** Procédé selon la revendication 1, **caractérisé en ce que** le terme $C_2$ est compris entre 0,85 et 1,05.

**5.** Procédé selon l'une des revendications précédentes, **caractérisé en ce que** la durée du quatrième intervalle, noté $M_z$, est choisie comme étant :

$$M_z = \left\lceil \frac{2M \times 7}{40} \right\rceil$$

où la notation $\lceil x \rceil$ désigne l'entier plus grand ou égal à x et le plus proche de x, $M$ correspondant à la durée d'un bloc.

**6.** Procédé selon l'une des revendications précédentes, **caractérisé en ce que** le premier intervalle, noté $R_1$, est de durée donnée par :

$$R_1 = \left\lfloor \frac{2M \times 404}{1280} + 0,5 \right\rfloor, \text{ où } M \text{ correspond à la durée d'un bloc,}$$

la notation $\lfloor x \rfloor$ désignant l'entier plus petit ou égal à x et le plus proche de x.

**7.** Procédé selon l'une des revendications précédentes, **caractérisé en ce que** le troisième intervalle, noté $R_2$, est de durée donnée par :

$$R_2 = \left\lfloor \frac{2M \times 196}{1280} + 0,5 \right\rfloor, \text{ où } M \text{ correspond à la durée d'un bloc,}$$

la notation $\lfloor x \rfloor$ désignant l'entier plus petit ou égal à x et le plus proche de x.

**8.** Procédé selon l'une des revendications précédentes, **caractérisé en ce que** le premier intervalle, noté $R_1$, est de durée donnée par :
$R_1 = \lfloor M - M_z + 1 + 0,5 \rfloor$, où $M$ correspond à la durée d'un bloc, et $M_z$ correspond à la durée du quatrième intervalle.

**9.** Procédé selon la revendication 8, **caractérisé en ce que** le troisième intervalle, noté $R_2$, est de durée donnée par :
$R_2 = \lfloor M - 2M_z + 1 + 0,5 \rfloor$, où $M$ correspond à la durée d'un bloc, et $M_z$ correspond à la durée du quatrième intervalle.

**10.** Procédé selon l'une des revendications précédentes, **caractérisé en ce qu'**il comporte l'application d'une pluralité de fenêtres successives, asymétriques et comportant lesdites quatre portions, à une succession de paires de blocs.

**11.** Procédé de décodage d'un signal numérique, codé par la mise en oeuvre du procédé selon l'une des revendications précédentes, le décodage étant du type par transformée avec recouvrement et comprenant, à la synthèse, l'application d'une fenêtre de pondération sur deux blocs d'échantillons codés successifs, **caractérisé en ce que** ladite fenêtre de pondération, à la synthèse, est identique à la fenêtre d'analyse utilisée au codage, retournée temporellement.

**12.** Programme informatique destiné à être stocké en mémoire d'un dispositif de codage ou de décodage, **caractérisé en ce qu'**il comporte des instructions pour la mise en oeuvre du procédé de codage selon l'une des revendications 1 à 10 ou du procédé de décodage selon la revendication 11, lorsque les instructions sont exécutées par un processeur du dispositif.

**13.** Dispositif de codage d'un signal, **caractérisé en ce qu'**il comporte des moyens de stockage (MEM) et/ou de calcul ($\mu$P) de données d'une fenêtre de pondération, d'analyse, pour la mise en oeuvre du procédé de codage selon l'une des revendications 1 à 10.

**14.** Dispositif de décodage d'un signal, **caractérisé en ce qu'**il comporte des moyens de stockage (MEM') et/ou de calcul ($\mu$P) de données d'une fenêtre de pondération, de synthèse, pour la mise en oeuvre du procédé de décodage selon la revendication 11.

**Patentansprüche**

1. Verfahren zur Codierung eines digitalen Signals, wobei das Signal aus aufeinanderfolgenden Blöcken von Abtastwerten besteht, wobei die Codierung vom Typ durch Überlappungstransformation ist, umfassend zur Analyse das Anwenden eines Gewichtungsfensters auf zwei aufeinanderfolgende Blöcke von M Abtastwerten, wobei das Gewichtungsfenster asymmetrisch ist und vier verschiedene Abschnitte umfasst, die sich aufeinanderfolgend über die zwei Blöcke erstrecken, mit:

   - einem ersten Abschnitt ($w_1$), der über ein erstes Intervall von Abtastwerten zunimmt,
   - einem zweiten Abschnitt ($w_2$), der auf einem Wert von 1 über ein zweites Intervall konstant ist,
   - einem dritten Abschnitt ($w_3$), der über ein drittes Intervall abnimmt, und
   - einem vierten Abschnitt ($w_4$), der auf einem Wert von 0 über ein viertes Intervall konstant ist,

   **dadurch gekennzeichnet, dass** das Fenster über das erste Intervall variiert, das als $R_1$ bezeichnet wird, als Funktion $w_1$ des Typs:

$$w_1(n) = \frac{W_1(n)}{\Delta_n(n)},$$

   wobei

$$W_1(n) = \sin\left(\frac{\pi}{2}\frac{n+1}{R_1}\right)^{C_1}$$

   und

$$\Delta_n(n) = \sqrt{h_i(n).h_i(2M-n-1) + h_i(n+M).h_i(M-n-1)}, \quad n \in [0;\ M-1],$$

   wobei $C_1$ und $R_1$ Konstanten größer als 0 sind, $h_i$ ein Initialisierungsfenster ist, und dadurch, dass das Fenster über das dritte Intervall variiert, das als $R_2$ bezeichnet wird, als Funktion $w_3$ des Typs:

$$w_3(n) = \frac{W_3(n)}{\Delta_n(n)},$$

   wobei

$$W_3(n) = \cos\left(\frac{\pi}{2}\frac{n}{R_2}\right)^{C_2},$$

   wobei $C_2$ und $R_2$ Konstanten größer als 0 sind.

2. Verfahren nach Anspruch 1, **dadurch gekennzeichnet, dass** das erste, zweite und dritte Intervall mindestens als Funktion des vierten Intervalls (Mz) berechnet werden.

3. Verfahren nach Anspruch 1, **dadurch gekennzeichnet, dass** der Term $C_1$ zwischen 3 und 5 beträgt.

4. Verfahren nach Anspruch 1, **dadurch gekennzeichnet, dass** der Term $C_2$ zwischen 0,85 und 1,05 beträgt

**5.** Verfahren nach einem der vorhergehenden Ansprüche, **dadurch gekennzeichnet, dass** die Dauer des vierten Intervalls, die als $M_z$ bezeichnet wird, ausgewählt wird als:

$$M_z = \left\lceil \frac{2M \times 7}{40} \right\rceil$$

wobei die Notation $\lceil x \rceil$ die größte ganze Zahl bezeichnet oder gleich x und die nächste von x, wobei M der Dauer eines Blocks entspricht.

**6.** Verfahren nach einem der vorhergehenden Ansprüche, **dadurch gekennzeichnet, dass** das erste Intervall, das als $R_1$ bezeichnet wird, eine Dauer aufweist, die gegeben ist durch:

$$R_1 = \left\lfloor \frac{2M \times 404}{1280} + 0{,}5 \right\rfloor,$$

wobei M der Dauer eines Blocks
entspricht,
wobei die Notation $\lceil x \rceil$ die kleinste ganze Zahl bezeichnet oder gleich x und die nächste von x.

**7.** Verfahren nach einem der vorhergehenden Ansprüche, **dadurch gekennzeichnet, dass** das dritte Intervall, das als $R_2$ bezeichnet wird, eine Dauer aufweist, die gegeben ist durch:

$$R_2 = \left\lfloor \frac{2M \times 196}{1280} + 0{,}5 \right\rfloor,$$

wobei M der Dauer eines Blocks entspricht,
wobei die Notation $\lceil x \rceil$ die kleinste ganze Zahl bezeichnet oder gleich x und die nächste von x.

**8.** Verfahren nach einem der vorhergehenden Ansprüche, **dadurch gekennzeichnet, dass** das erste Intervall, das als $R_1$ bezeichnet wird, eine Dauer aufweist, die gegeben ist durch:
$R_1 = \lfloor M - M_z + 1 + 0{,}5 \rfloor$, wobei M der Dauer eines Blocks entspricht, und $M_z$ der Dauer des vierten Intervalls entspricht.

**9.** Verfahren nach Anspruch 8, **dadurch gekennzeichnet, dass** das dritte Intervall, das als $R_2$ bezeichnet wird, eine Dauer aufweist, die gegeben ist durch:
$R_2 = \lfloor M - 2M_z + 1 + 0{,}5 \rfloor$, wobei M der Dauer eines Blocks entspricht, und $M_z$ der Dauer des vierten Intervalls entspricht.

**10.** Verfahren nach einem der vorhergehenden Ansprüche, **dadurch gekennzeichnet, dass** dieses umfasst: Anwenden einer Vielzahl aufeinanderfolgender asymmetrischer Fenster, und umfassend die vierten Abschnitte, in einer Folge von Blockpaaren.

**11.** Verfahren zur Decodierung eines digitalen Signals, das durch die Anwendung des Verfahrens nach einem der vorhergehenden Ansprüche codiert wird, wobei die Decodierung vom Typ durch Überlappungstransformation ist, und umfassend zur Synthese das Anwenden eines Gewichtungsfensters auf zwei aufeinanderfolgende codierte Blöcke von Abtastwerten,
**dadurch gekennzeichnet, dass** das Gewichtungsfenster zur Synthese identisch ist mit dem Fenster zur Analyse, das bei der Codierung angewendet wird, mit einer Zeitumkehr.

**12.** Computerprogramm, welches dazu bestimmt ist, im Speicher einer Codierungs- oder Decodierungsvorrichtung gespeichert zu werden, **dadurch gekennzeichnet, dass** dieses Instruktion zur Durchführung des Codierungsverfahrens nach einem der Ansprüche 1 bis 10 oder des Decodierungsverfahrens nach Anspruch 11 umfasst, wenn die Instruktionen von einem Prozessor der Vorrichtung ausgeführt werden.

**13.** Vorrichtung zur Codierung eines Signals, **dadurch gekennzeichnet, dass** diese Mittel zum Speichern (MEM) und/oder zum Berechnen ($\mu$P) von Daten eines Gewichtungsfensters zur Analyse zur Durchführung des Codierungsverfahrens nach einem der Ansprüche 1 bis 10 umfasst.

**14.** Vorrichtung zur Decodierung eines Signals, **dadurch gekennzeichnet, dass** diese Mittel zum Speichern (MEM')
und/oder zum Berechnen ($\mu$P) von Daten eines Gewichtungsfensters zur Synthese zur Durchführung des Decodierungsverfahrens nach Anspruch 11 umfasst.

**Claims**

**1.** Method for coding a digital signal, said signal being made up of successive blocks of samples, the coding being of
the transform with overlap type and comprising, upon analysis, the application of a weighting window over two
successive blocks of M samples,
said weighting window being asymmetrical and comprising four distinct portions extending in succession over said
two blocks, with:

  - a first portion ($w_1$), increasing over a first interval of samples,
  - a second portion ($w_2$), constant at a value of 1 over a second interval,
  - a third portion ($w_3$), decreasing over a third interval, and
  - a fourth portion ($w_4$), constant at a value of 0 over a fourth interval,

**characterized in that** the window varies over the first interval, denoted as a function $w_1$ of type:

$$w_1(n) = \frac{W_1(n)}{\Delta_n(n)}, \quad \text{with} \quad W_1(n) = \sin\left(\frac{\mathbf{p}}{2}\frac{n+1}{R_1}\right)^{C_1}$$

and:

$$\Delta_n(n) = \sqrt{h_i(n).h_i(2M-n-1)+h_i(n+M).h_i(M-n-1)} \quad ,$$

$n \in [0; M - 1]$ with $C_1$ and $R_1$, constants greater than 0, $h_i$ being an initialization window,
and **in that** the window varies over the third interval, denoted $R_2$, as a function $w_3$ of type:

$$w_3(n) = \frac{W_3(n)}{\Delta_n(n)}, \quad \text{with} \quad W_3(n) = \cos\left(\frac{\mathbf{p}}{2}\frac{n}{R_2}\right)^{C_2},$$

with $C_2$ and $R_2$, constants greater than 0.

**2.** Method according to Claim 1, **characterized in that** the first, second and third intervals are calculated at least as
a function of the fourth interval (Mz).

**3.** Method according to Claim 1, **characterized in that** the term $C_1$ is between 3 and 5.

**4.** Method according to Claim 1, **characterized in that** the term $C_2$ is between 0.85 and 1.05.

**5.** Method according to one of the preceding claims, **characterized in that** the duration of the fourth interval, denoted
$M_z$, is chosen to be:

$$M_z = \left\lceil \frac{2M \times 7}{40} \right\rceil$$

in which the notation $|x|$ designates the integer greater than or equal to x and closest to x, $M$ corresponding to the
duration of a block.

6. Method according to one of the preceding claims, **characterized in that** the first interval, denoted $R_1$, is of a duration given by:

$$R_1 = \left\lfloor \frac{2M \times 404}{1280} + 0.5 \right\rfloor \text{ , in which } M \text{ corresponds to the duration of a block,}$$

the notation $\lfloor x \rfloor$ designating the integer less than or equal to x and closest to x.

7. Method according to one of the preceding claims, **characterized in that** the third interval, denoted $R_2$, is of a duration given by:

$$R_2 = \left\lfloor \frac{2M \times 196}{1280} + 0.5 \right\rfloor \text{ , in which } M \text{ corresponds to the duration of a block,}$$

the notation $\lfloor x \rfloor$ designating the integer less than or equal to x and closest to x.

8. Method according to one of the preceding claims, **characterized in that** the first interval, denoted $R_1$, is of a duration given by:
$R_1 = \lfloor M - M_z + 1 + 0.5 \rfloor$, in which $M$ corresponds to the duration of a block, and $M_z$ corresponds to the duration of the fourth interval.

9. Method according to Claim 8, **characterized in that** the third interval, denoted $R_2$, is of a duration given by:
$R_2 = \lfloor M - 2M_z + 1 + 0.5 \rfloor$, in which $M$ corresponds to the duration of a block, and $M_z$ corresponds to the duration of the fourth interval.

10. Method according to one of the preceding claims, **characterized in that** it comprises the application of a plurality of successive windows, asymmetrical and comprising said four portions, to a succession of pairs of blocks.

11. Method for decoding a digital signal, coded by the implementation of the method according to one of the preceding claims, the decoding being of the transform with overlap type and comprising, upon synthesis, the application of a weighting window over two successive blocks of coded samples,
**characterized in that** said weighting window, upon synthesis, is identical to the analysis window used in the coding, temporally reversed.

12. Computer program intended to be stored in memory of a coding or decoding device, **characterized in that** it comprises instructions for the implementation of the coding method according to one of Claims 1 to 10 or of the decoding method according to Claim 11, when the instructions are executed by a processor of the device.

13. Signal coding device, **characterized in that** it comprises means for storing (MEM) and/or computing ($\mu$P) data of an analysis weighting window, for the implementation of the coding method according to one of Claims 1 to 10.

14. Signal decoding device, **characterized in that** it comprises means for storing (MEM') and/or computing ($\mu$P) data of a synthesis weighting window, for the implementation of the decoding method according to Claim 11.

FIG. 1

(N Ech)

FIG. 2

FIG. 3

FIG. 4

FIG. 5

FIG. 6

**FIG. 7**

**FIG. 8**

80 — INIT

81 — R1, R2
C1, C2

82 — hi

83 — Pfct REC
$ha = hi / \Delta n$

84 — OPT (ha)

85 — OPT ?

86 — UPD
R1, R2
C1, C2

KO

OK

87 — ha OPT

FIG. 9

FIG. 10

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2009081003 A